# EUROPEAN PATENT APPLICATION

(11) **EP 4 593 064 A1**
(43) Date of publication of application: **30.07.2025**
(21) Application number: 24217966.1
(22) Date of filing: 06.12.2024
(51) Int. Cl.: H01L 21/3213, H01L 21/67

(54) **SUBSTRATE PROCESSING METHOD AND SUBSTRATE PROCESSING APPARATUS**

(30) Priority: 25.12.2023 JP 2023217866
(71) Applicant: SCREEN Holdings Co., Ltd., Kyoto-shi, Kyoto 602-8585 (JP)
(72) Inventor: TAKAGI, Keisuke, Kyoto, 602-8585 (JP); TAKEMATSU, Yusuke, Kyoto, 602-8585 (JP); MAKI, Yusuke, Kyoto, 602-8585 (JP); NAKANO, Akiyoshi, Kyoto, 602-8585 (JP); MIZUKAMI, Daijo, Kyoto, 602-8585 (JP)
(74) Representative: Kilian Kilian & Partner mbB

(57) **Abstract**

A substrate processing method includes an outer etching step of etching an outer portion by supplying an etching liquid to a substrate including an end surface, an inner surface forming a gap which has a width smaller than a depth of the gap and is open at the end surface, and the etching target having an outer portion disposed outside the gap and an inner portion disposed in the gap, and an inner etching step of etching the inner portion with a mixed etching liquid which has entered the gap by supplying, to the substrate, the mixed etching liquid which is an etching liquid obtained by dissolving a low-surface-tension liquid having a surface tension smaller than a surface tension of the etching liquid, after the outer portion of the etching target is etched.

## Description

### BACKGROUND OF THE INVENTION

### 1. Field of the Invention

The present invention relates to a substrate processing method and a substrate processing apparatus that process substrates. The substrates include a semiconductor wafer, a substrate for a FPD (flat panel display) such as a liquid crystal display and an organic EL (electroluminescence) display, a substrate for an optical disc, a substrate for a magnetic disk, a substrate for a magneto-optical disc, a substrate for a photomask, a ceramic substrate, a substrate for a solar cell, and the like.

### 2. Description of Related Art

JP 2023-123997 A discloses a substrate processing liquid for performing etching processing on a substrate having a trench structure. Paragraph 0019 of JP 2023-123997 A describes that "by adding a complex formation agent containing anions that form complexes with ions of a metal (Ti in the embodiment) and adjusting the pH of the substrate processing liquid to 1 or more and 6 or less, the amount of an etchant can be increased, and the etchant can efficiently enter an inside of the trench structure, that is, a narrow space 12f".

However, in the invention described in JP 2023-123997 A, the substrate processing liquid having the same components is continuously supplied from start to end of the etching processing.

At least one embodiment of the present invention provides a substrate processing method and a substrate processing apparatus enabling an etching target disposed outside and inside a gap to be etched while reducing usage of components contained in a liquid supplied to a substrate when the etching target is etched.

### SUMMARY OF THE INVENTION

An embodiment of the present invention provides a substrate processing method including an outer etching step of etching an outer portion of an etching target by supplying an etching liquid to a substrate including an end surface, an inner surface forming a gap which has a width smaller than a depth of the gap and is open at the end surface, and the etching target having an outer portion disposed outside the gap and an inner portion disposed in the gap, and an inner etching step of etching, after the outer portion of the etching target is etched, the inner portion of the etching target with a mixed etching liquid that has entered the gap by supplying, to the substrate, the mixed etching liquid which is the etching liquid in which a low-surface-tension liquid having a surface tension smaller than a surface tension of the etching liquid is dissolved.

In the embodiment, at least one of the following features may be added to the substrate processing method.

The inner etching step includes a step of supplying the mixed etching liquid to the substrate after the entire outer portion of the etching target is etched.

The inner etching step includes a step of changing a concentration of the low-surface-tension liquid in the mixed etching liquid which is to be supplied to the substrate.

The low-surface-tension liquid is IPA (isopropyl alcohol).

The substrate processing method further includes a rinse liquid supplying step of supplying a rinse liquid containing water to the substrate to wash away the mixed etching liquid in contact with the substrate with the rinse liquid, after the inner portion of the etching target is etched.

The substrate includes two channels stacked in a thickness direction of the substrate in a state of being separated from each other, and two gate insulating films which are respectively in contact with the two channels in a state of being separated from each other, and surfaces of the two gate insulating films form the gap.

Another embodiment of the present invention provides a substrate processing apparatus including an etching liquid nozzle that etches an outer portion of an etching target by supplying an etching liquid to a substrate including an end surface, an inner surface forming a gap which has a width smaller than a depth of the gap and is open at the end surface, and the etching target having an outer portion disposed outside the gap and an inner portion disposed in the gap, and a mixed etching liquid nozzle that is the same as or different from the etching liquid nozzle and etches, after the outer portion of the etching target is etched, the inner portion of the etching target with a mixed etching liquid which has entered the gap by supplying, to the substrate, the mixed etching liquid which is the etching liquid in which a low-surface-tension liquid having a surface tension smaller than a surface tension of the etching liquid is dissolved. At least one of the above-described features regarding the substrate processing method may be added to the substrate processing apparatus.

In the embodiment, at least one of the following features may be added to the substrate processing apparatus.

The mixed etching liquid nozzle supplies the mixed etching liquid to the substrate after the entire outer portion of the etching target is etched.

The substrate processing apparatus further includes a valve that changes a concentration of the low-surface-tension liquid in the mixed etching liquid which is to be supplied to the substrate.

The low-surface-tension liquid is IPA (isopropyl alcohol).

The substrate processing apparatus further includes a rinse liquid nozzle that supplies a rinse liquid containing water to the substrate to wash away the mixed etching liquid in contact with the substrate with the rinse liquid, after the inner portion of the etching target is etched.

### BRIEF DESCRIPTION OF THE DRAWINGS

FIG. 1 is a schematic cross-sectional view of a substrate according to an embodiment.
FIG. 2A is an enlarged view showing an example of a cross section of the substrate.
FIG. 2B is an enlarged view showing another example of the cross section of the substrate.
FIGS. 3A to 3C are schematic cross-sectional views of the substrate for illustrating etching of an etching target.
FIGS. 3D to 3F are schematic cross-sectional views of the substrate for illustrating etching of the etching target.
FIG. 4 is a graph showing a temporal change in total etching amount of the etching target and a temporal change in concentration of a low-surface-tension liquid.
FIG. 5 is a flowchart for illustrating etching of the etching target.
FIG. 6 is a schematic plan view showing a layout of a substrate processing apparatus.
FIG. 7 is a schematic view of an interior of a processing unit provided in the substrate processing apparatus when viewed horizontally.
FIG. 8A is a schematic view of a processing liquid preparing system to prepare a processing liquid to be supplied to the substrate such as an etching liquid.
FIG. 8B is a schematic view of a processing liquid preparing system to prepare a processing liquid to be supplied to the substrate such as an etching liquid.
FIG. 8C is a schematic view of a processing liquid preparing system to prepare a processing liquid to be supplied to the substrate such as an etching liquid.
FIG. 8D is a schematic view of a processing liquid preparing system to prepare a processing liquid to be supplied to the substrate such as an etching liquid.
FIG. 8E is a schematic view of a processing liquid preparing system to prepare a processing liquid to be supplied to the substrate such as an etching liquid.

### DETAILED DESCRIPTION OF PREFERRED EMBODIMENTS

Embodiments of the present invention will be explained in detail with reference to the accompanying drawings.

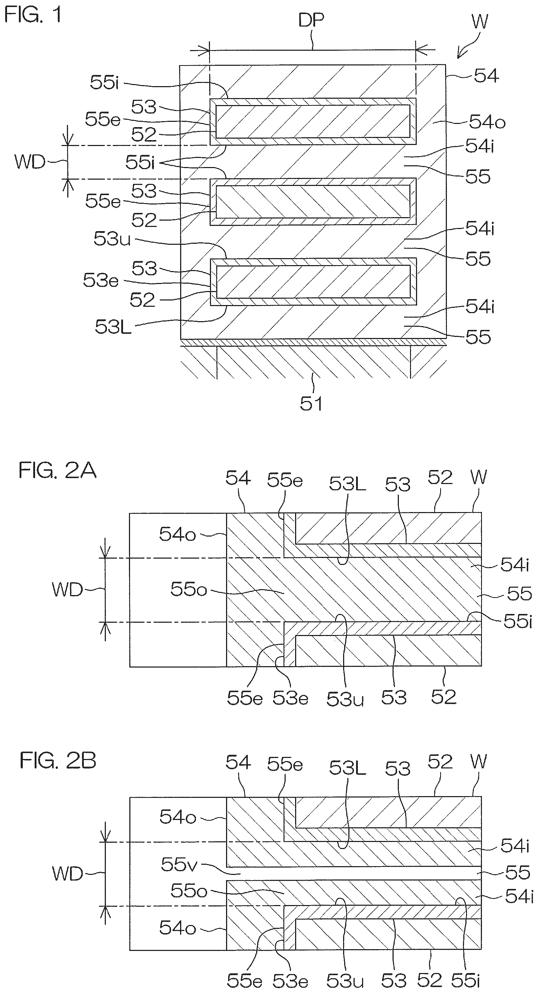

FIG. 1 is a schematic cross-sectional view of a substrate W according to an embodiment. FIG. 2A is an enlarged view showing an example of a cross section of the substrate W. FIG. 2B is an enlarged view showing another example of the cross section of the substrate W.

A width direction, a depth direction, and a length direction of a gap 55 are three directions orthogonal to each other. The depth direction of the gap 55 is a direction (a left-right direction of the paper surface in FIG. 2A) perpendicular to a plane including an opening portion 55o (see FIG. 2A) corresponding to an entrance of the gap 55. The width direction of the gap 55 is a direction (an up-down direction of the paper surface in FIG. 2A) parallel to the shortest line segment connecting two points on an outline of the opening portion 55o of the gap 55. An etching rate corresponds to an etching speed that is an etching amount per unit time.

FIG. 1 shows a metal-oxide-semiconductor field-effect transistor (MOSFET) in production. FIG. 1 shows an example in which the MOSFET in production is a complementary metal oxide semiconductor (CMOS) in production. A manufacturing process of the CMOS includes etching processing of removing a gate material from only a P-type MOSFET after the gate material is deposited on an N-type MOSFET and the P-type MOSFET. In an example shown in FIG. 1, a sacrificial layer or a sacrificial film that is made from a gate material for an N-type MOSFET and deposited in a channel 52 of a P-type MOSFET through a gate insulating film 53 is an etching target 54.

A MOSFET shown in FIG. 1 is an example of a semiconductor device formed on a plate-shaped substrate 51 made of a semiconductor or a compound semiconductor. The semiconductor device may be a field effect transistor (FET) other than a MOSFET, or may be a semiconductor device other than an FET. The MOSFET may be either of a nanosheet FET (also called a ribbon FET) and a forksheet FET, or may be a MOSFET other than these FETs. The nanosheet FET is an example of a gate-all-around (GAA) FET in which a gate surrounds the entire circumference of the channel 52 around a straight line (a straight line perpendicular to the paper surface in FIG. 1) parallel to a long side of the channel 52.

FIG. 1 shows an example in which a P-type MOSFET of the CMOS in production is a nanosheet FET in production. The nanosheet FET in production includes a plurality of channels 52, a plurality of gate insulating films 53, and an etching target 54. The channel 52 is a region through which a current flowing from a source to a drain passes. The channel 52 has a rectangular sheet shape parallel to the substrate 51. The plurality of channels 52 are stacked in the thickness direction of the substrate W (the up-down direction of the paper surface in FIG. 1) in a state of being separated from each other. Any one of the channels 52 is surrounded by one gate insulating film 53 provided for each channel 52. The gate insulating film 53 is in contact with the entire circumference of the channel 52. The etching target 54 is in contact with all the gate insulating films 53.

The channel 52 is made of a semiconductor such as silicon or germanium. The gate insulating film 53 is made of a high dielectric constant material (high-k material). The high dielectric constant material may be any of HfO₂, Al₂O₃, and La₂O₃, or may be a material other than these materials. The etching target 54 may be made of a metal such as TiN, TaN, TaAlN, or TiC or a metal compound, or may be made of a material other than metals and metal compounds.

As described below, when the etching target 54 is etched, an etching liquid is supplied to the substrate W. The etching liquid may be SC2 which is a mixed liquid of hydrochloric acid, hydrogen peroxide water, and water, SC1 which is a mixed liquid of ammonia water, hydrogen peroxide water, and water, or diluted hydrogen peroxide water, or may be an etching liquid other than these liquids. The etching liquid is a liquid that etches the etching target 54 and does not or hardly etches the gate insulating film 53. When the etching liquid is supplied to the etching target 54 and the gate insulating film 53, an etching rate of the etching target 54 is higher than an etching rate of the gate insulating film 53.

After the etching liquid is supplied, the mixed etching liquid is supplied to the substrate W. The mixed etching liquid is the etching liquid in which a low-surface-tension liquid having a surface tension smaller than that of the etching liquid is dissolved. The low-surface-tension liquid is isopropyl alcohol (IPA) or methanol. If the low-surface-tension liquid is soluble in the etching liquid, the low-surface-tension liquid may be an organic solvent other than IPA and methanol, or may be a liquid other than the organic solvent. The etching liquid may be either hydrophilic or hydrophobic. If the low-surface-tension liquid is IPA or methanol, the low-surface-tension liquid is soluble in the etching liquid regardless of whether the etching liquid is hydrophilic or hydrophobic. When the etching liquid is SC2 and the low-surface-tension liquid is IPA, a concentration of IPA in the mixed etching liquid may be within or out of a range of 5 vol% to 30 vol%.

As shown in FIG. 1, the substrate W forms at least one gap 55 housing a portion of the etching target 54. FIG. 1 shows an example in which a plurality of gaps 55 are formed. The gap 55 has a rectangular sheet shape having the same shape and size as those of the other gaps 55. The plurality of gaps 55 are arranged in parallel at equal intervals such that long sides of the plurality of gaps 55 overlap each other and short sides of the plurality of gaps 55 overlap each other when viewed in a direction perpendicular to the plurality of gaps 55 (the up-down direction of a paper surface in FIG. 1). FIG. 1 shows an example in which the gap 55 extends horizontally. The gap 55 may extend vertically.

As shown in FIGS. 2A and 2B, the gap 55 includes a rectilinear opening portion 55o extending in the length direction of the gap 55 (a direction perpendicular to the paper surface in FIGS. 2A and 2B). The opening portion 55o corresponds to the entrance of the gap 55. FIG. 1 shows an example in which the gap 55 is a bottomless gap 55 in which both ends of the gap 55 in the depth direction of the gap 55 (the left-right direction of the paper surface in FIG. 1) are open. The gap 55 may be a bottomed gap 55 having a U-shaped cross section. In either case, both ends of the gap 55 in the length direction of the gap 55 (the direction perpendicular to the paper surface in FIG. 1) may be open or closed. One end of the gap 55 in the length direction of the gap 55 may be open, and the other end of the gap 55 in the length direction of the gap 55 may be closed.

The substrate W includes an end surface 55e forming an entrance of the gap 55 and inner surfaces 55i forming an inside of the gap 55. In the example shown in FIG. 1, a left end surface 53e of each gate insulating film 53 corresponds to the end surface 55e, and an upper surface 53u and a lower surface 53L of each gate insulating film 53 correspond to the inner surfaces 55i. One gap 55 is formed by two gate insulating films 53 adjacent to each other in the width direction of the gap 55 (the up-down direction of the paper surface in FIG. 1). In other words, one gap 55 is disposed between the upper surface 53u of a gate insulating film 53 and the lower surface 53L of another gate insulating film 53 located above the gate insulating film 53.

The end surface 55e forming the entrance of the gap 55 is a rectangular flat surface perpendicular to the depth direction of the gap 55. A long side of the end surface 55e is parallel to the length direction of the gap 55, and a short side of the end surface 55e is parallel to the width direction of the gap 55. The inner surface 55i forming the inside of the gap 55 is a rectangular flat surface perpendicular to the width direction of the gap 55. A long side of the inner surface 55i is parallel to the depth direction of the gap 55, and a short side of the end surface 55e is parallel to the width direction of the gap 55. The inner surface 55i extends in the depth direction of the gap 55 from the end surface 55e toward the inside of the gap 55.

Right end surfaces of the plurality of gate insulating films 53 are separated in the width direction of the gap 55. The same applies to the left end surfaces 53e of the plurality of gate insulating films 53. The same applies to the upper surfaces 53u and the lower surfaces 53L of the plurality of gate insulating films 53. The right end surface of each of the plurality of gate insulating films 53 forms an entrance or an exit of the gap 55. The left end surface 53e of each of the plurality of gate insulating films 53 also forms the entrance or the exit of the gap 55. The upper surfaces 53u and the lower surfaces 53L of the plurality of gate insulating films 53 form the inside of the gap 55.

A width WD of the gap 55 corresponds to an interval of the gap 55 in the width direction between the two gate insulating films 53 forming one gap 55. A depth DP (see FIG. 1) of the gap 55 corresponds to a length of the gate insulating film 53 in the depth direction of the gap 55. A length of the gap 55 corresponds to a length of the gate insulating film 53 in the length direction of the gap 55. The width WD of the gap 55 is shorter than the depth DP of the gap 55. The width WD of the gap 55 is shorter than the length of the gap 55. The depth DP of the gap 55 may be equal to or different from the length of the gap 55.

FIG. 1 shows an example in which the width WD of the gap 55 is equal at any position in the depth direction of the gap 55 (the left-right direction of the paper surface in FIG. 1). The width WD of the gap 55 may change depending on a position in the depth direction of the gap 55. When each of the upper surface 53u and the lower surface 53L of the gate insulating film 53 corresponds to the inner surface 55i, the width WD of the gap 55 may be equal to or different from a thickness (a length in the up-down direction of the paper surface in FIG. 1) of the gate insulating film 53, that is, an interval of the gap 55 in the width direction between the upper surface 53u and the lower surface 53L of one gate insulating film 53. The width WD of the gap 55 may be equal to or different from a thickness of the channel 52. The width WD of the gap 55 may be 1 nm or larger and 10 nm or smaller, may be 1 nm or larger and 6 nm or smaller, or may be out of these ranges.

The etching target 54 is disposed not only inside the gap 55 but also outside the gap 55. The etching target 54 includes an outer portion 54o disposed outside the gap 55 and an inner portion 54i disposed inside the gap 55. In the example shown in FIG. 1, since a plurality of gaps 55 are formed, a plurality of inner portions 54i are provided in the etching target 54. The plurality of inner portions 54i are arranged one by one in the plurality of gaps 55.

The inner portion 54i of the etching target 54 is in contact with the inner surface 55i forming the inside of the gap 55. FIGS. 1 and 2A show an example in which the inner portion 54i is disposed in the entirety of the gap 55 and the gap 55 is filled with the inner portions 54i. As shown in FIG. 2B, the inner portions 54i may form a void 55v in the gap 55. In this case, the etching target 54 may have two inner portions 54i disposed in one gap 55. The two inner portions 54i may be partially or entirely separated such that the void 55v is formed between the two inner portions 54i. As shown in FIG. 2B, the void 55v between the two inner portions 54i may be open at a surface of the outer portion 54o.

The outer portion 54o of the etching target 54 is in contact with the plurality of end surfaces 55e. The outer portion 54o covers two end surfaces 55e adjacent to each other in the width direction of the gap 55. As shown in FIG. 2A, the outer portion 54o blocks the entrance of the gap 55. As shown in FIG. 2B, the etching target 54 may have a plurality of outer portions 54o separated from each other in the width direction of the gap 55. In this case, the outer portions 54o may not block the entirety or portion of the entrance of the gap 55. The outer portion 54o is continuous with the inner portion 54i. The outer portion 54o is integrated with the inner portion 54i. A thickness of the outer portion 54o (a length of the outer portion 54o in a direction perpendicular to the end surface 55e) may be equal to or different from a thickness of the inner portion 54i (a length of the inner portion 54i in a direction perpendicular to the inner surface 55i).

The thickness of the outer portion 54o is smaller than the depth DP (see FIG. 1) of the gap 55. The thickness of the outer portion 54o may be equal to or different from the width WD of the gap 55. The thickness of the outer portion 54o may be equal to or different from the thickness of the gate insulating film 53. The thickness of the outer portion 54o may be equal to or different from the thickness of the channel 52. The same content as this paragraph applies to the thickness of the inner portion 54i.

Next, etching of the etching target 54 will be described.

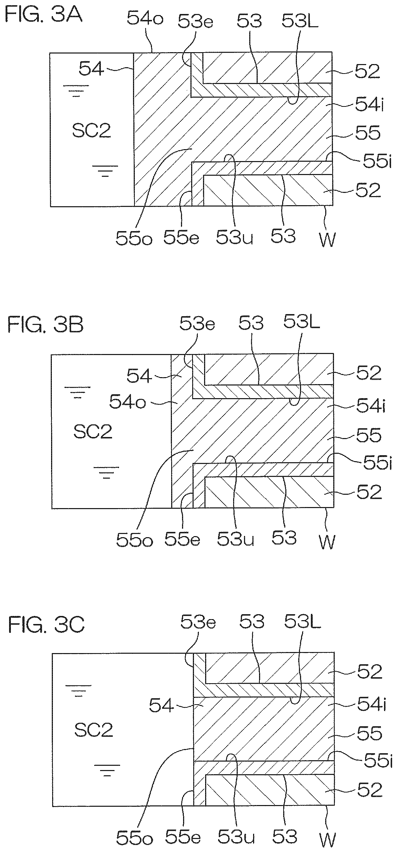

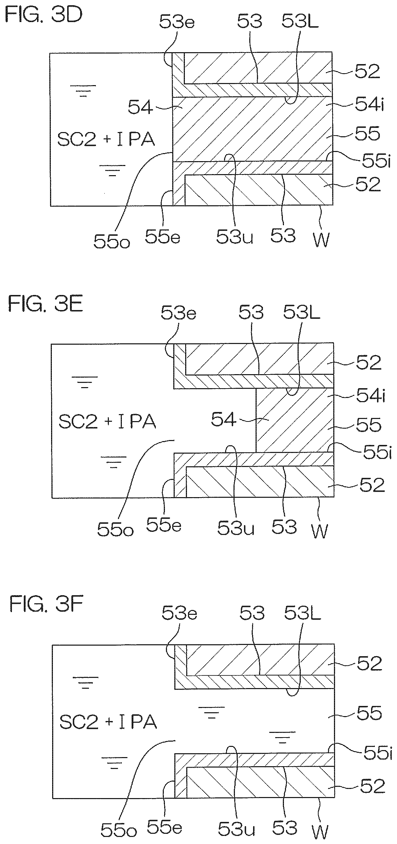

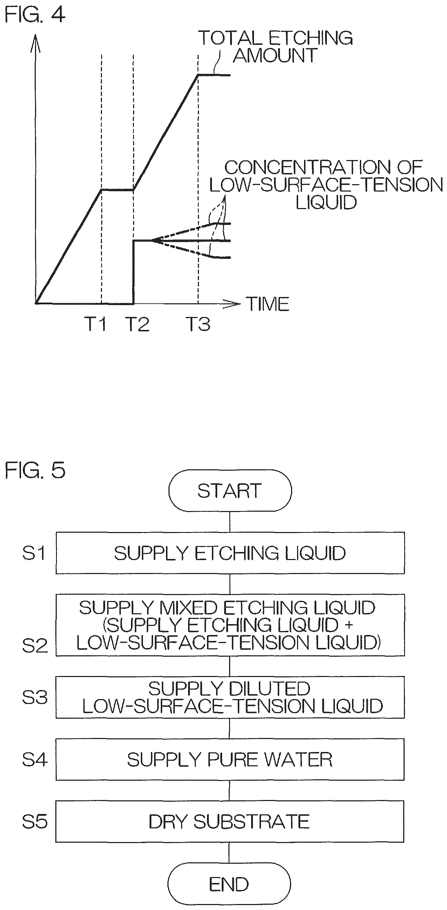

FIGS. 3A, 3B, 3C, 3D, 3E, and 3F are schematic cross-sectional views of the substrate W for illustrating the etching of the etching target 54. FIG. 4 is a graph showing a temporal change in total etching amount of the etching target 54 and a temporal change in concentration of the low-surface-tension liquid. FIG. 5 is a flowchart for illustrating the etching of the etching target 54. FIGS. 3A to 3F show an example in which the etching liquid is SC2 and the low-surface-tension liquid is IPA.

When the etching target 54 is etched, an etching liquid is supplied to an upper surface of the substrate W that is horizontally held with a front surface of the substrate W facing upward (step S1 in FIG. 5). This allows a liquid film of the etching liquid which covers the entire upper surface of the substrate W to be formed.

When the etching liquid is supplied to the upper surface of the substrate W, the etching liquid may be supplied while the substrate W remains stationary, or the etching liquid may be supplied while the substrate W is rotated around a vertical rotational axis passing a central portion of the substrate W. If a state where the entire upper surface of the substrate W is covered with the liquid film of the etching liquid is maintained, the etching liquid may be continuously added to the upper surface of the substrate W while the etching liquid is spun off from an outer periphery of the substrate W, or the etching liquid may be held on the upper surface of the substrate W while the addition of the etching liquid to the substrate W is stopped. In the latter case, the substrate W may be stopped or rotated at a low speed (for example, 30 rpm or lower) in a state where the entire upper surface of the substrate W is covered with the etching liquid. A temperature of the etching liquid before being supplied to the substrate W may be equal to or different from room temperature (for example, 20°C to 30°C). The same content as this paragraph applies to supplying of the mixed etching liquid and a rinse liquid to the upper surface of the substrate W.

As shown in FIGS. 3A and 3B, the etching liquid supplied to the substrate W chemically reacts with a surface of the etching target 54 to dissolve the surface of the etching target 54 in the etching liquid. The outer portion 54o of the etching target 54 is disposed outside the gap 55, whereas the inner portion 54i of the etching target 54 is disposed in the gap 55. When the outer portion 54o blocks the entrance of the gap 55, the etching liquid gradually dissolves the outer portion 54o in the etching liquid. Even when the outer portion 54o does not block the entrance of the gap 55, the etching liquid is unlikely to enter the gap 55, so that the etching liquid gradually dissolves the outer portion 54o in the etching liquid. Hence, for a while after the supply of the etching liquid is started, the outer portion 54o is etched at an etching rate higher than an etching rate of the inner portion 54i.

As shown in FIG. 3C, when a reaction between the etching target 54 and the etching liquid continues, the entire outer portion 54o of the etching target 54 is etched while the inner portion 54i of the etching target 54 remains in the substrate W. When the entire outer portion 54o is etched, that is, when the outer portion 54o is completely removed from the substrate W, the amount of the etching target 54 contained in the etching liquid discharged from the substrate W (including a substance generated by a chemical reaction with the etching liquid) decreases to 0 or a value approximate to 0. Whether or not the entire outer portion 54o has been etched may be determined based on an elapsed time from the start of the supply of the etching liquid, or may be determined based on the etching liquid discharged from the substrate W.

When whether or not the entire outer portion 54o has been etched is determined based on the etching liquid discharged from the substrate W, the concentration of the etching target 54 contained in the etching liquid discharged from the substrate W may be monitored, or the pH (hydrogen ion exponent) of the etching liquid discharged from the substrate W may be monitored. When a color of the etching liquid changes depending on the content of the etching target 54, the color of the etching liquid discharged from the substrate W may be monitored. When the etching target 54 is a metal or a metal compound, the conductivity of the etching liquid discharged from the substrate W may be monitored. The same content as this paragraph applies to determining whether or not the entire inner portion 54i has been etched, based on the mixed etching liquid discharged from the substrate W.

After the entire outer portion 54o of the etching target 54 is etched, the mixed etching liquid is supplied to the upper surface of the substrate W as shown in FIG. 3D (step S2 in FIG. 5). This allows a liquid film of the mixed etching liquid which covers the entire upper surface of the substrate W to be formed.

The mixed etching liquid is the etching liquid in which the low-surface-tension liquid having a surface tension smaller than that of the etching liquid is dissolved. The etching liquid which is supplied to the substrate W when the outer portion 54o of the etching target 54 is etched may be a liquid which does not contain the low-surface-tension liquid, or may be a liquid which contains the low-surface-tension liquid as long as a concentration of the low-surface-tension liquid is lower than a concentration of the low-surface-tension liquid in the mixed etching liquid. When the etching liquid is SC2, a concentration of an etchant in the etching liquid means a concentration of hydrogen chloride and hydrogen peroxide. A concentration of an etchant in the mixed etching liquid may be equal to or different from the concentration of the etchant in the etching liquid.

When the mixed etching liquid is supplied to the upper surface of the substrate W, the etching liquid and the low-surface-tension liquid mixed with each other before being brought into contact with the substrate W may be brought into contact with the substrate W, or the low-surface-tension liquid may be dissolved in the etching liquid that is in contact with the substrate W. When the mixed etching liquid is supplied to the upper surface of the substrate W, ejection of the mixed etching liquid may be started while the etching liquid is ejected toward the upper surface of the substrate W, and then the ejection of the etching liquid may be stopped. Alternatively, after the ejection of the etching liquid is stopped, the ejection of the mixed etching liquid may be started. In this case, the ejection of the mixed etching liquid may be started after a predetermined time has elapsed from the stop of the ejection of the etching liquid, or may be started at the same time or substantially the same time as the stop of the ejection of the etching liquid.

As shown in FIGS. 3D and 3E, the mixed etching liquid supplied to the substrate W chemically reacts with the surface of the etching target 54 to dissolve the surface of the etching target 54 in the mixed etching liquid. Although the inner portion 54i of the etching target 54 is disposed in the gap 55 having a narrow width, the mixed etching liquid enters the gap 55 since the surface tension of the mixed etching liquid is smaller than the surface tension of the etching liquid. This allows the inner portion 54i of the etching target 54 to be etched by the mixed etching liquid.

The etching of the inner portion 54i causes a surface of the inner portion 54i to be continuously moved in the depth direction of the gap 55 from the vicinity of the entrance of the gap 55. When the inner portions 54i form, in the gap 55, the elongated void 55v (see FIG. 2B) extending in the depth direction of the gap 55, the mixed etching liquid enters the void 55v and widens a width of the void 55v. In this manner, the inner portion 54i is gradually dissolved in the mixed etching liquid. As shown in FIG. 3F, when a reaction between the etching target 54 and the mixed etching liquid continues, the entire inner portion 54i of the etching target 54 is etched.

The concentration of the mixed etching liquid which is to be supplied to the substrate W may be kept constant or may be changed from start to end of the supply of the mixed etching liquid. An alternate long and two short dashes line in FIG. 4 indicates an example in which the concentration of the low-surface-tension liquid in the mixed etching liquid increases or decreases.

When the reaction between the etching target 54 and the mixed etching liquid continues, a distance from the entrance of the gap 55 to the surface of the inner portion 54i in the depth direction of the gap 55 increases, so that there is a possibility that the mixed etching liquid will be difficult to reach the surface of the inner portion 54i. If the concentration of the low-surface-tension liquid in the mixed etching liquid is increased continuously or stepwise, the surface tension of the mixed etching liquid decreases, and thus such a possibility can be reduced.

On the other hand, when the inner portions 54i form, in the gap 55, the elongated void 55v (see FIG. 2B) extending in the depth direction of the gap 55, the mixed etching liquid widens the width of the void 55v. In this case, the concentration of the low-surface-tension liquid in the mixed etching liquid may be decreased continuously or stepwise. This enables the mixed etching liquid to be continuously supplied into the gap 55 while usage of the low-surface-tension liquid is reduced.

FIG. 4 shows an example of a temporal change in total etching amount of the etching target 54. When the supply of the etching liquid to the substrate W is started, the total etching amount of the etching target 54 increases in proportion to an elapsed time from the start of the supply of the etching liquid. When the entire outer portion 54o of the etching target 54 is etched, the increase in the total etching amount stops. FIG. 4 shows an example in which the increase in the total etching amount stops at a time T1 and the total etching amount is maintained the same until a time T2. A period from the start of the supply of the etching liquid to the time T1 corresponds to an outer etching step.

In the example shown in FIG. 4, supply of the mixed etching liquid to the substrate W is started at the time T2. When the supply of the mixed etching liquid is started, the etching of the inner portion 54i of the etching target 54 is started. Therefore, the total etching amount of the etching target 54 increases again in proportion to an elapsed time from the start of the supply of the mixed etching liquid. When the entire inner portion 54i of the etching target 54 is etched, the increase in the total etching amount is stopped again. FIG. 4 shows an example in which the increase in the total etching amount is stopped at a time T3. A period from the time T2 to the time T3 corresponds to an inner etching step.

Since the inner portion 54i of the etching target 54 is disposed in the narrow gap 55 and the etching liquid is unlikely to enter the gap 55, it is possible to etch the outer portion 54o of the etching target 54 while the inner portion 54i of the etching target 54 is not or is hardly etched. By supplying the etching liquid to the substrate W for a time or longer during which it is assumed that the entire outer portion 54o of the etching target 54 is etched, it is possible to remove the entire outer portion 54o from the substrate W while the inner portion 54i of the etching target 54 is not or is hardly etched.

When the supply of the mixed etching liquid is started, the entire outer portion 54o is removed from the substrate W, and the inner portion 54i remains in the gap 55. The etching of the inner portion 54i substantially starts when the supply of the mixed etching liquid is started. Hence, the total etching amount of the inner portion 54i can be accurately controlled by adjusting the time during which the mixed etching liquid is supplied. Further, if the mixed etching liquid is supplied to the substrate W for a time or longer during which it is assumed that the entire inner portion 54i is etched, the entire inner portion 54i can be removed from the substrate W.

After the entire inner portion 54i of the etching target 54 is etched, the mixed etching liquid is washed away with a rinse liquid such as pure water (deionized water (DIW)) (steps S3 and S4 in FIG. 5), and the substrate W is dried (step S5 in FIG. 5).

A liquid adhering to the substrate W during drying of the substrate W is defined as a final rinse liquid. The mixed etching liquid may be washed away with the final rinse liquid, or an intermediate rinse liquid may be washed away with the final rinse liquid after the mixed etching liquid is washed away with the intermediate rinse liquid. In the latter case, a diluted low-surface-tension liquid (low-surface-tension liquid diluted with pure water) may be the intermediate rinse liquid, and the pure water may be the final rinse liquid. FIG. 5 shows an example in which the mixed etching liquid is washed away with the diluted low-surface-tension liquid corresponding to the intermediate rinse liquid (step S3 in FIG. 5), and then the diluted low-surface-tension liquid is washed away with pure water corresponding to the final rinse liquid (step S4 in FIG. 5).

After the rinse liquid is supplied to the entire upper surface of the substrate W, the substrate W to which a liquid such as the rinse liquid adheres is dried. A method of drying the substrate W may be spin drying of removing the liquid from the substrate W by rotating the substrate W at a high speed, or may be a method other than the spin drying, such as decompression drying of evaporating the liquid in contact with the substrate W by reducing the pressure in a housing space housing the substrate W.

Next, a substrate processing apparatus 1 that etches the etching target 54 will be described.

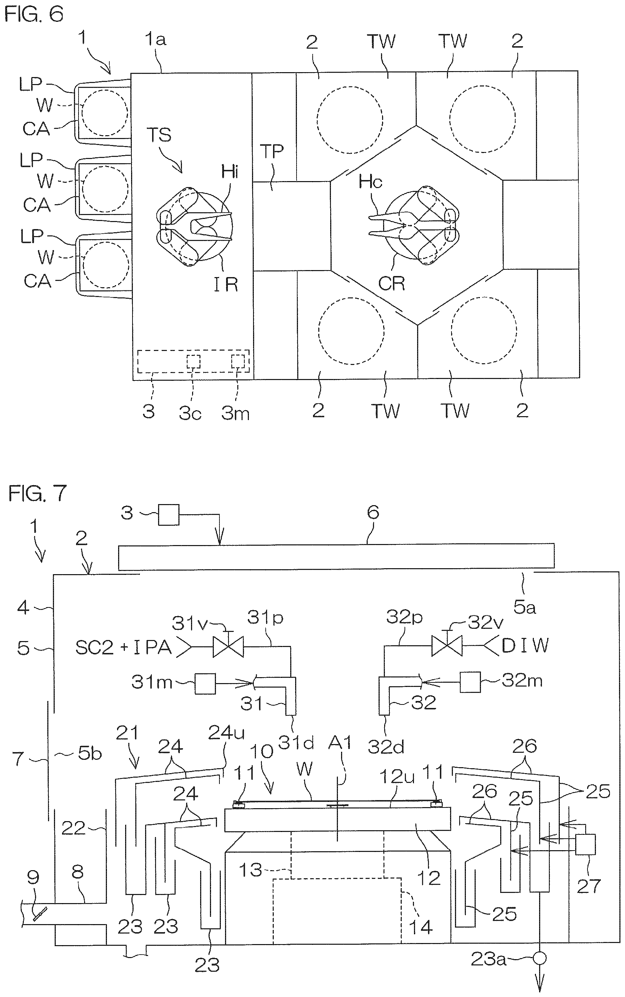

FIG. 6 is a schematic plan view showing a layout of the substrate processing apparatus 1. The substrate processing apparatus 1 is a single substrate processing type apparatus that processes disk-shaped substrates W such as semiconductor wafers one by one. The substrate processing apparatus 1 includes a load port LP that holds a carrier CA housing the substrates W, a plurality of processing units 2 that process the substrates W transferred from the carrier CA on the load port LP with a processing fluid such as a processing liquid or processing gas, a transfer system TS that transfers the substrates W between the carrier CA on the load port LP and the plurality of processing units 2, an outer wall 1a that forms a sealed space housing the plurality of processing units 2 and the transfer system TS, and a controller 3 that controls the substrate processing apparatus 1.

The plurality of processing units 2 form a plurality of towers TW. FIG. 6 shows an example where four towers TW are formed. A plurality of processing units 2 included in a single tower TW are stacked vertically. The plurality of towers TW form two rows extending in the length direction (the left-right direction of the paper in 6) of the substrate processing apparatus 1 in a plan view. The two rows face each other across a transport path TP in a plan view.

The transport system TS includes an indexer robot IR that transports the substrate W between the carrier CA on the load port LP and the plurality of processing units 2, and a center robot CR that transports the substrate W between the indexer robot IR and the plurality of processing units 2. The indexer robot IR is disposed between the load port LP and the center robot CR in a plan view. The center robot CR is disposed in the transport path TP.

The indexer robot IR includes one or more hands Hi that support the substrates W horizontally. The hand Hi is movable in parallel in both the horizontal direction and the vertical direction. The hand Hi is rotatable around a vertical line. The hand Hi can carry in and carry out the substrate W to and from the carrier CA on any of the load ports LP, and can receive and transfer the substrate W from and to the center robot CR.

The center robot CR includes one or more hands Hc that support the substrates W horizontally. The hand Hc is movable in parallel in both the horizontal direction and the vertical direction. The hand Hc is rotatable around a vertical line. The hand Hc can receive and transfer the substrate W from and to the indexer robot IR, and carry in and carry out the substrate W to and from any of the processing units 2.

The controller 3 controls electrical devices and electronic devices provided in the substrate processing apparatus 1. The controller 3 includes at least one computer. The computer includes a memory 3m that stores information such as a program, and a CPU 3c (Central Processing Unit) that controls the substrate processing apparatus 1 according to the program stored in the memory 3m. The controller 3 controls the substrate processing apparatus 1 to carry out transfer and processing of the substrate W. In other words, the controller 3 is programmed to carry out transfer and processing of the substrate W.

Next, a processing unit 2 will be described.

FIG. 7 is a schematic view of an interior of the processing unit 2 provided in the substrate processing apparatus 1 when viewed horizontally. The processing unit 2 includes a box-shaped chamber 4 having an interior space, a spin chuck 10 that rotates one substrate W around a vertical rotational axis A1 passing through the central portion of the substrate W while holding it horizontally in the chamber 4, and a tubular processing cup 21 surrounding the spin chuck 10 around the rotational axis A1.

The chamber 4 includes a box-shaped partition 5 provided with a carry-in and carry-out opening 5b through which the substrate W passes, and a door 7 that opens and closes the carry-in and carry-out opening 5b. An FFU 6 (fan filter unit) is disposed on an air outlet 5a provided in the upper portion of the partition 5. The FFU 6 constantly supplies clean air (air that has been filtered by a filter) from the air outlet 5a to the chamber 4. The gas in the chamber 4 is discharged from the chamber 4 through a discharged gas duct 8 connected to the bottom portion of the processing cup 21. Thereby, a downflow of clean air is constantly formed inside the chamber 4. The flow rate of discharged gas to be discharged into the discharged gas duct 8 is changed according to the opening degree of a discharged gas valve 9 located in the discharged gas duct 8.

The spin chuck 10 includes a disk-shaped spin base 12 horizontally held, a plurality of chuck pins 11 that hold the substrate W horizontally above the spin base 12, a spin shaft 13 extending downward from the central portion of the spin base 12, and a spin motor 14 that rotates the spin base 12 and the plurality of chuck pins 11 by rotating the spin shaft 13.

The spin chuck 10 is not limited to a gripping-type chuck that contacts the plurality of chuck pins 11 with the end surface of substrate W, and may be a vacuum-type chuck that holds the substrate W horizontally by adsorbing the rear surface (lower surface) of the substrate W, which is a non-device forming surface, onto the upper surface 12u of the spin base 12. When the spin chuck 10 is the gripping-type chuck, the plurality of chuck pins 11 correspond to a substrate holder. When the spin chuck 10 is the vacuum-type chuck, the spin base 12 corresponds to the substrate holder.

The processing cup 21 includes a plurality of guards 24 that receive processing liquid discharged outward from the substrate W, a plurality of cups 23 that receive the processing liquid guided downward by the plurality of guards 24, and a tubular outer wall 22 surrounding the plurality of guards 24 and the plurality of cups 23. FIG. 7 shows an example where four guards 24 and three cups 23 are provided, the outermost side cup 23 being integral with the 3rd guard 24 from the top.

The guard 24 includes a cylindrical portion 25 surrounding the spin chuck 10, and a toric ceiling portion 26 extending upward obliquely from the upper end portion of the cylindrical portion 25 toward the rotational axis A1. The plurality of ceiling portions 26 overlap in the vertical direction, and the plurality of cylindrical portions 25 are disposed in a concentric manner. The toric upper end of the ceiling portion 26 corresponds to the upper end 24u of the guard 24 surrounding the substrate W and the spin base 12 in a plan view. The plurality of cups 23 are disposed under the plurality of cylindrical portions 25, respectively. The cup 23 forms an annular groove that receives processing liquid guided downward by the guard 24. A sensor 23a such as a concentration meter to measure the concentration of the processing liquid discharged from the cup 23 or a pH meter to measure the pH of the processing liquid may be provided.

The processing unit 2 includes a guard raising/lowering unit 27 that individually raises and lowers the plurality of guards 24. The guard raising/lowering unit 27 positions the guard 24 at any position within a range from an upper position to a lower position. FIG. 7 shows a state where two guards 24 are disposed at the upper position and the remaining two guards 24 are disposed at the lower position. The upper position is a position where the upper end 24u of the guard 24 is disposed above a holding position where the substrate W held by the spin chuck 10 is positioned. The lower position is a position where the upper end 24u of the guard 24 is disposed below the holding position.

The actuator is a device that converts driving energy, which represents electrical, fluid, magnetic, thermal or chemical energy, to mechanical work, that is, motion of a tangible object. The actuator includes an electric motor (rotary motor), linear motor, air cylinder and other devices. If the motion of the actuator is different from the motion of the object, a motion converter may be provided to convert the motion of the actuator into linear motion or rotation. For example, if the actuator is an electric motor and the object is to be moved in a linear motion, a motion converter, such as a ball screw and ball nut, may convert the rotation of the electric motor into linear motion.

The processing unit 2 includes an etching liquid nozzle 31 that ejects the etching liquid toward the upper surface of the substrate W held by the spin chuck 10, and a rinse liquid nozzle 32 that ejects a rinse liquid toward the upper surface of the substrate W held by the spin chuck 10. The etching liquid nozzle 31 also serves as a mixed etching liquid nozzle that ejects the mixed etching liquid toward the upper surface of the substrate W held by the spin chuck 10. FIG. 7 shows an example in which a mixed liquid of SC2 and IPA is supplied to the etching liquid nozzle 31, and DIW is supplied to the rinse liquid nozzle 32. The mixed liquid of SC2 and IPA is an example of the mixed etching liquid.

The etching liquid nozzle 31 is connected to an etching liquid pipe 31p that guides the etching liquid. When an etching liquid valve 31v attached to the etching liquid pipe 31p is opened, an outlet 31d of the etching liquid nozzle 31 continuously ejects the etching liquid downward. The rinse liquid nozzle 32 is connected to a rinse liquid pipe 32p that guides the rinse liquid. When a rinse liquid valve 32v attached to the rinse liquid pipe 32p is opened, an outlet 32d of the rinse liquid nozzle 32 continuously ejects the rinse liquid downward. The rinse liquid may be any of pure water, carbonated water, electrolyzed ionized water, hydrogen water, ozone water, and hydrochloric acid solution having a dilution concentration (for example, about 10 to 100 ppm), or may be a liquid other than these.

Although not shown, the etching liquid valve 31v includes a valve body provided with an annular valve seat through which etching liquid passes, a valve element that can move with respect to the valve seat, and an actuator that moves the valve element between a closed position where the valve element contacts the valve seat and an open position where the valve element is away from the valve seat. The same applies to other valves. The actuator may be a pneumatic actuator or an electric actuator, or may be an actuator other than these. The controller 3 opens and closes the etching liquid valve 31v and the like by controlling the actuator.

The etching liquid nozzle 31 may be a scan nozzle that shifts a landing position of the etching liquid on the substrate W within the upper surface of the substrate W, or may be a fixed nozzle that is not capable of moving the landing position of the etching liquid with respect to the substrate W. The same applies to other nozzles. FIG. 7 shows an example in which the etching liquid nozzle 31 and the rinse liquid nozzle 32 are scan nozzles.

The etching liquid nozzle 31 is connected to a nozzle moving actuator 31m that moves the etching liquid nozzle 31 in at least one direction of the vertical direction and the horizontal direction. The nozzle moving actuator 31m horizontally moves the etching liquid nozzle 31 between a processing position (position shown in FIG. 7) where the etching liquid ejected from the etching liquid nozzle 31 is supplied to the upper surface of the substrate W and a standby position where the etching liquid nozzle 31 is positioned around the processing cup 21 in a plan view.

The rinse liquid nozzle 32 is connected to a nozzle moving actuator 32m that moves the rinse liquid nozzle 32 in at least one direction of the vertical direction and the horizontal direction. The nozzle moving actuator 32m horizontally moves the rinse liquid nozzle 32 between a processing position (position shown in FIG. 7) where the rinse liquid ejected from the rinse liquid nozzle 32 is supplied to the upper surface of the substrate W and a standby position where the rinse liquid nozzle 32 is positioned around the processing cup 21 in a plan view.

Next, a method of preparing the etching liquid or the like will be described.

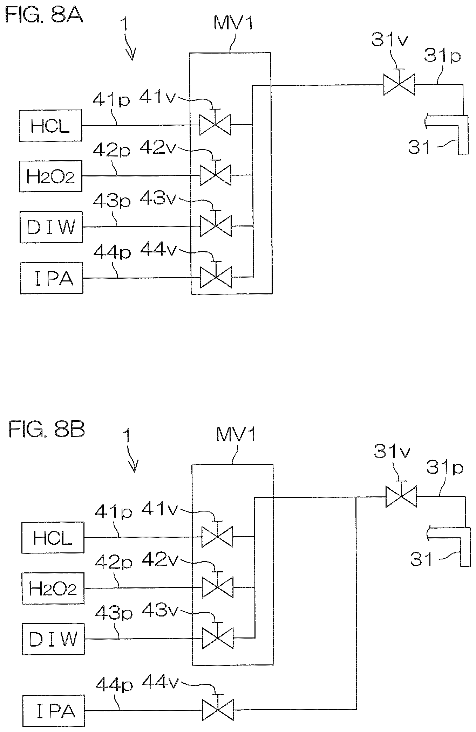

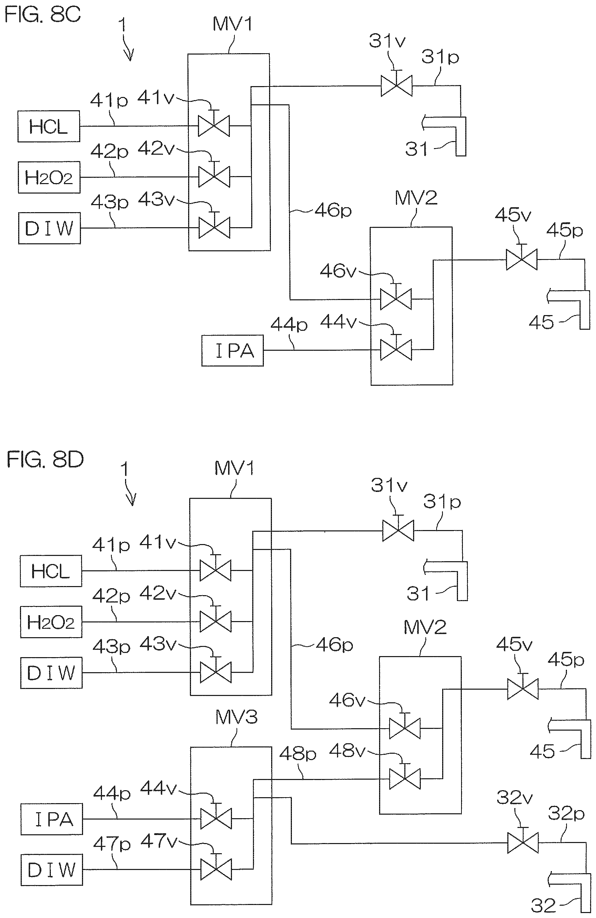

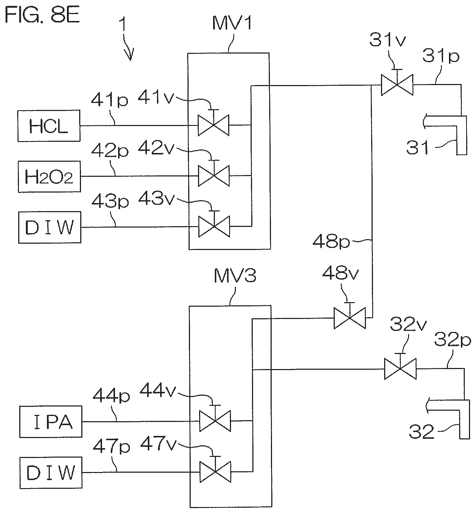

FIG. 8A, FIG. 8B, FIG. 8C, FIG. 8D, and FIG. 8E are schematic views of processing liquid preparing systems to prepare a processing liquid to be supplied to the substrate W such as an etching liquid. FIGS. 8A to 8E show an example in which the etching liquid is SC2 which is a mixed liquid of hydrochloric acid, hydrogen peroxide water, and water, and the low-surface-tension liquid is IPA.

In the example shown in FIG. 8A, the substrate processing apparatus 1 includes a first component pipe 41p that guides hydrochloric acid, which is an example of a first component liquid, a second component pipe 42p that guides hydrogen peroxide water, which is an example of a second component liquid, and a third component pipe 43p that guides pure water, which is an example of a third component liquid. The substrate processing apparatus 1 further includes a low-surface-tension liquid pipe 44p that guides IPA, which is an example of the low-surface-tension liquid.

FIG. 8A shows an example in which the first component pipe 41p, the second component pipe 42p, the third component pipe 43p, and the low-surface-tension liquid pipe 44p are connected to the etching liquid pipe 31p. In this example, the first component pipe 41p, the second component pipe 42p, the third component pipe 43p, and the low-surface-tension liquid pipe 44p are connected to the etching liquid pipe 31p through a mixing valve MV1.

When a first component valve 41v attached to the first component pipe 41p is opened, hydrochloric acid is supplied to the mixing valve MV1 at a flow rate corresponding to an opening degree of the first component valve 41v. When a second component valve 42v attached to the second component pipe 42p is opened, hydrogen peroxide water is supplied to the mixing valve MV1 at a flow rate corresponding to an opening degree of the second component valve 42v. When a third component valve 43v attached to the third component pipe 43p is opened, pure water is supplied to the mixing valve MV1 at a flow rate corresponding to an opening degree of the third component valve 43v.

The first component valve 41v is a valve that serves as both an on-off valve that switches between an opened state where a liquid such as hydrochloric acid is allowed to pass and a closed state where the liquid is stopped, and a flow rate adjusting valve that stabilizes the flow rate of the passing liquid at any value within a certain range. The same applies to the second component valve 42v and the third component valve 43v. The same applies to valves to be described below, such as a low-surface-tension liquid valve 44v. In place of the first component valve 41v, a separate on-off valve and flow rate adjustment valve may be attached to the first component pipe 41p. The same applies to other pipes.

When the first component valve 41v, the second component valve 42v, the third component valve 43v, and the etching liquid valve 31v are opened, hydrochloric acid, hydrogen peroxide water, and water are mixed by the mixing valve MV1, and SC2, which is a mixed liquid thereof, is supplied from the mixing valve MV1 to the etching liquid nozzle 31 through the etching liquid pipe 31p.

When the low-surface-tension liquid valve 44v attached to the low-surface-tension liquid pipe 44p is opened, IPA is supplied to the mixing valve MV1 at a flow rate corresponding to an opening degree of the low-surface-tension liquid valve 44v. When the low-surface-tension liquid valve 44v is opened in addition to the first component valve 41v, the second component valve 42v, the third component valve 43v, and the etching liquid valve 31v, the mixed liquid of SC2 and IPA is supplied from the mixing valve MV1 to the etching liquid nozzle 31 through the etching liquid pipe 31p.

In the example shown in FIG. 8B, the first component pipe 41p, the second component pipe 42p, the third component pipe 43p, and the etching liquid pipe 31p are connected to the mixing valve MV1, and the low-surface-tension liquid pipe 44p is connected to the etching liquid pipe 31p. When the first component valve 41v, the second component valve 42v, the third component valve 43v, and the etching liquid valve 31v are opened, SC2 is supplied from the mixing valve MV1 to the etching liquid nozzle 31 through the etching liquid pipe 31p.

When the low-surface-tension liquid valve 44v is opened in addition to the first component valve 41v, the second component valve 42v, the third component valve 43v, and the etching liquid valve 31v, SC2 and IPA are mixed in the etching liquid pipe 31p, and the mixed liquid of SC2 and IPA is supplied to the etching liquid nozzle 31. The low-surface-tension liquid pipe 44p may be connected to the etching liquid nozzle 31 in addition to or instead of the etching liquid pipe 31p.

In the example shown in FIG. 8C, a mixed etching liquid nozzle 45 that ejects the mixed etching liquid toward the upper surface of the substrate W held by the spin chuck 10 (see FIG. 7) is provided. The mixed etching liquid nozzle 45 is connected to a mixed etching liquid pipe 45p to which a mixed etching liquid valve 45v is attached. The etching liquid pipe 31p is connected to the first component pipe 41p, the second component pipe 42p, and the third component pipe 43p. The mixed etching liquid pipe 45p is connected to the first component pipe 41p, the second component pipe 42p, and the third component pipe 43p through an intermediate pipe 46p. The mixed etching liquid pipe 45p is further connected to the low-surface-tension liquid pipe 44p.

FIG. 8C shows an example in which the first component pipe 41p, the second component pipe 42p, and the third component pipe 43p are connected to the mixing valve MV1, and the intermediate pipe 46p and the low-surface-tension liquid pipe 44p are connected to a mixing valve MV2. The etching liquid pipe 31p extends from the mixing valve MV1 to the etching liquid nozzle 31. The intermediate pipe 46p extends from the mixing valve MV1 to the mixing valve MV2. The mixed etching liquid pipe 45p extends from the mixing valve MV2 to the mixed etching liquid nozzle 45.

When the first component valve 41v, the second component valve 42v, the third component valve 43v, and the etching liquid valve 31v are opened, SC2, which is a mixed liquid of hydrochloric acid, hydrogen peroxide water, and water, is supplied from the mixing valve MV1 to the etching liquid nozzle 31 through the etching liquid pipe 31p. When an intermediate valve 46v attached to the intermediate pipe 46p is opened in addition to the first component valve 41v, the second component valve 42v, and the third component valve 43v, SC2 is supplied from the mixing valve MV1 to the mixing valve MV2.

In addition to the first component valve 41v, the second component valve 42v, and the third component valve 43v, the intermediate valve 46v, the low-surface-tension liquid valve 44v, and the mixed etching liquid valve 45v are opened, SC2 and IPA are supplied to the mixing valve MV2. This allows the mixed liquid of SC2 and IPA to be supplied from the mixing valve MV2 to the mixed etching liquid nozzle 45 through the mixed etching liquid pipe 45p.

In the example shown in FIG. 8D, similar to the example shown in FIG. 8C, an etching liquid nozzle 31 and a mixed etching liquid nozzle 45 are provided. The low-surface-tension liquid pipe 44p is connected not only to the mixed etching liquid pipe 45p but also to the rinse liquid pipe 32p. The rinse liquid pipe 32p is connected to the pure water pipe 47p in addition to the low-surface-tension liquid pipe 44p. In the example shown in FIG. 8D, the rinse liquid pipe 32p is connected to the low-surface-tension liquid pipe 44p and the pure water pipe 47p through a mixing valve MV3. The low-surface-tension liquid pipe 44p and the pure water pipe 47p are connected to the mixing valve MV2 through an intermediate pipe 48p.

When a pure water valve 47v attached to the pure water pipe 47p is opened, pure water is supplied to the mixing valve MV3 at a flow rate corresponding to an opening degree of the pure water valve 47v. At least one of IPA and pure water is supplied from the mixing valve MV3 to the rinse liquid nozzle 32 through the rinse liquid pipe 32p. When an intermediate valve 48v attached to the intermediate pipe 48p is opened, at least one of IPA and pure water is supplied from the mixing valve MV3 to the mixing valve MV2 through the intermediate pipe 48p.

In the example shown in FIG. 8E, the first component pipe 41p, the second component pipe 42p, the third component pipe 43p, and the etching liquid pipe 31p are connected to the mixing valve MV1, and the low-surface-tension liquid pipe 44p and the pure water pipe 47p are connected to the mixing valve MV3. The intermediate pipe 48p is not connected to the mixing valve MV2 shown in FIG. 8D but is connected to the etching liquid pipe 31p. When the low-surface-tension liquid valve 44v and the intermediate valve 48v are opened, IPA is supplied from the mixing valve MV3 to the etching liquid nozzle 31 through the intermediate pipe 48p. The intermediate pipe 48p may be connected to the etching liquid nozzle 31 in addition to or instead of the etching liquid pipe 31p.

Next, the advantages according to the embodiment will be described.

In the embodiment, the etching liquid to etch the etching target 54 is supplied to the substrate W. The substrate W includes the inner surface 55i that forms a gap 55 which is open at the end surface 55e. The outer portion 54o of the etching target 54 is disposed outside the gap 55, whereas the inner portion 54i of the etching target 54 is disposed in the gap 55. Since the width WD of the gap 55 is smaller than the depth DP of the gap 55, the etching liquid is unlikely to enter the gap 55. Hence, when the etching liquid is supplied to the substrate W, the outer portion 54o of the etching target 54 is etched.

After the outer portion 54o of the etching target 54 is etched, the mixed etching liquid is supplied to the substrate W. The mixed etching liquid is the etching liquid in which the low-surface-tension liquid having a surface tension smaller than a surface tension of the etching liquid is dissolved. Since the surface tension of the mixed etching liquid is smaller than the surface tension of the etching liquid, the mixed etching liquid enters the gap 55, and the inner portion 54i of the etching target 54 is etched. Hence, as compared to a case where the mixed etching liquid is continuously supplied from the beginning, the outer portion 54o and the inner portion 54i of the etching target 54 can be removed from the substrate W while the usage of the low-surface-tension liquid is reduced. By reducing the usage of the low-surface-tension liquid such as IPA, a burden on the environment can be reduced.

In the embodiment, after the entire outer portion 54o of the etching target 54 is etched, the mixed etching liquid is supplied to the substrate W. In other words, the etching liquid is continuously supplied to the substrate W, not the mixed etching liquid, until the entire outer portion 54o of the etching target 54 is etched. Hence, the usage of the low-surface-tension liquid can be reduced as compared with a case where the supply of the mixed etching liquid is started before the entire outer portion 54o of the etching target 54 is etched.

In the embodiment, the concentration of the low-surface-tension liquid in the mixed etching liquid may be increased or decreased continuously or stepwise. By increasing the concentration of the low-surface-tension liquid, the mixed etching liquid can reach a position deep in the gap 55. On the other hand, when the inner portions 54i form, in the gap 55, the elongated void 55v (see FIG. 2B) extending in the depth direction of the gap 55, the mixed etching liquid widens the width of the void 55v. In this case, when the concentration of the low-surface-tension liquid is reduced, the mixed etching liquid can be continuously supplied into the gap 55 while the usage of the low-surface-tension liquid is reduced.

In the embodiment, IPA which is an example of the low-surface-tension liquid is dissolved in the etching liquid, by which the mixed etching liquid is produced. A molecule of IPA has both a hydrophobic group and a hydrophilic group. Hence, even when the etching liquid is either hydrophilic or hydrophobic, IPA can be dissolved in the etching liquid. Additionally, IPA has a smaller (lower) surface tension than water. Hence, by dissolving IPA in the etching liquid, a mixed etching liquid having a small surface tension can be produced.

In the embodiment, after the inner portion 54i of the etching target 54 is etched with the mixed etching liquid containing IPA, a rinse liquid containing water (for example, pure water or a low-surface-tension liquid diluted with pure water) is supplied to the substrate W. This allows the mixed etching liquid adhering to the substrate W to be replaced with the rinse liquid. A molecule of IPA has both a hydrophobic group and a hydrophilic group. Hence, even when a trace amount of IPA remains in the substrate W, IPA is dissolved in the rinse liquid and is dispersed in the rinse liquid. IPA in the rinse liquid is removed from the substrate W in a process up to drying the substrate W. This makes it possible to reduce the amount of IPA remaining in the substrate W to a very small amount.

In the embodiment, the two channels 52 are stacked in the thickness direction of the substrate W in a state of being separated from each other, and one gate insulating film 53 is in contact with one channel 52. The two gate insulating films 53 are separated from each other. Surfaces of the two gate insulating films 53 include the end surface 55e and the inner surface 55i. Hence, the surfaces of the two gate insulating films 53 form the gap 55, and the inner portion 54i of the etching target 54 is disposed between the two gate insulating films 53. An interval between the two channels 52 in the thickness direction of the substrate W is on the order of nm and is very narrow. An interval between the two gate insulating films 53 in the thickness direction of the substrate W is narrower. By dissolving the low-surface-tension liquid in the etching liquid, the mixed etching liquid can enter such a narrow gap 55, and the inner portion 54i can be etched.

Next, other embodiments will be described.

Instead of starting the supply of the mixed etching liquid to the substrate W after the entire outer portion 54o of the etching target 54 is etched, the supply of the mixed etching liquid may be started in a state where the outer portion 54o remains in the substrate W.

The substrate processing apparatus 1 is not restricted to an apparatus to process a disc-shaped substrate W, and may be an apparatus to process a polygonal substrate W. The substrate processing apparatus 1 may be a batch type apparatus that processes a plurality of substrates W in a batch.

The batch-type substrate processing apparatus 1 may include an etching liquid bath to store the etching liquid in which a plurality of substrates W are immersed, and a mixed etching liquid bath to store the mixed etching liquid in which a plurality of substrates W are immersed. Instead of providing the mixed etching liquid bath, the low-surface-tension liquid may be added to the etching liquid in the etching liquid bath, or the etching liquid in the etching liquid bath may be replaced with the mixed etching liquid, after the etching liquid is supplied to the plurality of substrates W.

Terms describing a shape, a position, a size, or the like such as perpendicular, parallel, horizontal, vertical, or planar do not require strict accuracy when an object is observed on the order of nm. For example, perpendicular includes not only a case where an angle at which two objects intersect is 90 degrees, but also a case where the angle is substantially 90 degrees.

Two or more arrangements among all the arrangements described above may be combined. Two or more steps among all the steps described above may be combined.

The embodiments of the present invention are described in detail above, however, these are just detailed examples used for clarifying the technical contents of the present invention, and the present invention should not be limitedly interpreted to these detailed examples, and the spirit and scope of the present invention should be limited only by the claims appended hereto.

This application claims the benefit of priority to Japanese Patent Application No. 2023-217866 filed on December 25, 2023. The entire contents of this application are hereby incorporated herein by reference.

## Claims

1. A substrate processing method comprising:
an outer etching step of etching an outer portion (54o) of an etching target (54) by supplying an etching liquid to a substrate (W) including an end surface (55e), an inner surface (55i) forming a gap (55) which has a width smaller than a depth of the gap (55) and is open at the end surface (55e), and the etching target (54) having the outer portion (54o) disposed outside the gap (55) and an inner portion (54i) disposed in the gap (55); and
an inner etching step of etching, after the outer portion (54o) of the etching target (54) is etched, the inner portion (54i) of the etching target (54) with a mixed etching liquid which has entered the gap (55) by supplying, to the substrate (W), the mixed etching liquid which is the etching liquid in which a low-surface-tension liquid having a surface tension smaller than a surface tension of the etching liquid is dissolved.

2. The substrate processing method according to claim 1, wherein the inner etching step includes a step of supplying the mixed etching liquid to the substrate (W) after the entire outer portion (54o) of the etching target (54) is etched.

3. The substrate processing method according to claim 1 or 2, wherein the inner etching step includes a step of changing a concentration of the low-surface-tension liquid in the mixed etching liquid which is to be supplied to the substrate (W) .

4. The substrate processing method according to claim 1 or 2, wherein the low-surface-tension liquid is IPA (isopropyl alcohol).

5. The substrate processing method according to claim 4, further comprising a rinse liquid supplying step of supplying a rinse liquid containing water to the substrate (W) to wash away the mixed etching liquid in contact with the substrate (W) with the rinse liquid, after the inner portion (54i) of the etching target (54) is etched.

6. The substrate processing method according to claim 1 or 2, wherein
the substrate (W) includes two channels (52) stacked in a thickness direction of the substrate (W) in a state of being separated from each other, and two gate insulating films (53) which are in contact with the two channels (52) in a state of being separated from each other, and
surfaces of the two gate insulating films (53) form the gap (55).

7. A substrate processing apparatus (1) comprising:
an etching liquid nozzle (31) that etches an outer portion (54o) of an etching target (54) by supplying an etching liquid to a substrate (W) including an end surface (55e), an inner surface (55i) forming a gap (55) which has a width smaller than a depth of the gap (55) and is open at the end surface (55e), and the etching target (54) having the outer portion (54o) disposed outside the gap (55) and an inner portion (54i) disposed in the gap (55); and
a mixed etching liquid nozzle (31, 45) that is the same as or different from the etching liquid nozzle (31) and etches, after the outer portion (54o) of the etching target (54) is etched, the inner portion (54i) of the etching target (54) with a mixed etching liquid which has entered the gap (55) by supplying, to the substrate (W), the mixed etching liquid which is the etching liquid in which a low-surface-tension liquid having a surface tension smaller than a surface tension of the etching liquid is dissolved.

8. The substrate processing apparatus (1) according to claim 7, wherein the mixed etching liquid nozzle (31, 45) supplies the mixed etching liquid to the substrate (W) after the entire outer portion (54o) of the etching target (54) is etched.

9. The substrate processing apparatus (1) according to claim 7 or 8, further comprising a valve (41v, 42v, 43v, 44v, 45v, 46v, 47v, 48v) that changes a concentration of the low-surface-tension liquid in the mixed etching liquid which is to be supplied to the substrate (W).

10. The substrate processing apparatus (1) according to claim 7 or 8, wherein the low-surface-tension liquid is IPA (isopropyl alcohol).

11. The substrate processing apparatus (1) according to claim 10, further comprising a rinse liquid nozzle (32) that supplies a rinse liquid containing water to the substrate (W) to wash away the mixed etching liquid in contact with the substrate (W) with the rinse liquid, after the inner portion (54i) of the etching target (54) is etched.
